(19) **Europäisches Patentamt / European Patent Office / Office européen des brevets**

(11) **EP 1 858 155 A1**

(12) **EUROPÄISCHE PATENTANMELDUNG**

(43) Veröffentlichungstag:
21.11.2007 Patentblatt 2007/47

(51) Int Cl.:
*H03B 5/18* (2006.01)　　*H01P 7/08* (2006.01)
*H03B 5/12* (2006.01)　　*H03H 7/01* (2006.01)

(21) Anmeldenummer: 07006777.2

(22) Anmeldetag: 31.03.2007

(84) Benannte Vertragsstaaten:
**AT BE BG CH CY CZ DE DK EE ES FI FR GB GR HU IE IS IT LI LT LU LV MC MT NL PL PT RO SE SI SK TR**
Benannte Erstreckungsstaaten:
**AL BA HR MK YU**

(30) Priorität: **17.05.2006 DE 102006023353**

(71) Anmelder: **ATMEL Duisburg GmbH**
**47057 Duisburg (DE)**

(72) Erfinder: **Rai, Samir El**
**47057 Duisburg (DE)**

(74) Vertreter: **Müller, Wolf-Christian**
**Patentanwalt**
**Maaßstraße 32/1**
**69123 Heidelberg (DE)**

(54) **Integrierter Schwingkreis**

(57) Die Erfindung betrifft einen integrierten Schwingkreis zum Bereitstellen eines hochfrequenten Ausgangssignals, beinhaltend einen ersten Ausgang zum Bereitstellen eines ersten hochfrequenten Ausgangssignals mit einer ersten Frequenz und einer ersten Amplitude, eine mit dem ersten Ausgang verbundene erste induktive Einheit und eine mit dem ersten Ausgang verbundene erste kapazitive Einheit. Erfindungsgemäß ist ein zweiter Ausgang zum Bereitstellen eines zweiten hochfrequenten Ausgangssignals mit einer zweiten Frequenz und einer zweiten Amplitude vorgesehen, wobei die zweite Frequenz mit der ersten Frequenz übereinstimmt und sich die zweite Amplitude von der ersten Amplitude unterscheidet, und ist eine mit dem ersten Ausgang und mit dem zweiten Ausgang verbundene zweite induktive Einheit und eine mit dem zweiten Ausgang verbundene zweite kapazitive Einheit vorgesehen. Die Erfindung betrifft weiterhin einen spannungsgesteuerten Oszillator und eine integrierte Schaltung.

FIG.1

**Beschreibung**

Die vorliegende Erfindung betrifft einen integrierten Schwingkreis nach dem Oberbegriff des Patentanspruchs 1. Die Erfindung betrifft weiterhin einen spannungsgesteuerten Oszillator sowie eine integrierte Schaltung.

Die Erfindung liegt auf dem Gebiet integrierter Schaltungen (integrated circuits, IC). Sie liegt insbesondere auf dem Gebiet integrierter Schwingkreise (tank circuits) zum Bereitstellen eines hochfrequenten Ausgangssignals mit einer vorgegebenen (Ziel)Frequenz. Solche Schwingkreise werden vielfach in Hochfrequenz-Schaltungsanordnungen (radio frequency, RF) wie spannungsgesteuerten Oszillatoren, Verstärkern, Filter, Amplitudenregler, Tuner etc. in Sende-/Empfangsvorrichtungen von Telekommunikationssystemen eingesetzt.

Aus US 6,778,022 B1 ist ein Schwingkreis mit einer Induktivität und einer Kapazität bekannt (Fig. 2A), der an einem Ausgang ein Ausgangssignal mit einer vorgegebenen Frequenz bereitstellt.

Nachteilig ist hierbei, dass sich bei größeren Amplituden des Ausgangssignals, d.h. im Großsignalbetrieb, die Eigenschaften des Schwingkreises, wie z.B. die effektive Güte und/oder die Frequenzkonstanz verschlechtern. Nachteilig ist weiterhin die Belastung des Schwingkreises durch nachgeschaltete Ausgangssignalbuffer sowie die evtl. erforderliche aktive Dämpfung des Ausgangssignals.

Vor diesem Hintergrund liegt der Erfindung die Aufgabe zugrunde, einfach und kostengünstig zu implementierende integrierte Schwingkreise und spannungsgesteuerte Oszillatoren anzugeben, die im Großsignalbetrieb bessere Eigenschaften aufweisen, so dass leistungsfähige integrierte Schaltungen aufwandsgünstig realisiert werden können.

Erfindungsgemäß wird diese Aufgabe gelöst durch einen integrierten Schwingkreis mit den Merkmalen des Patentanspruchs 1, einen spannungsgesteuerten Oszillator mit den Merkmalen des Patentanspruchs 15 und durch eine integrierte Schaltung mit den Merkmalen des Patentanspruchs 16.

Der erfindungsgemäße integrierte Schwingkreis zum Bereitstellen eines hochfrequenten Ausgangssignals beinhaltet (A) einen ersten Ausgang zum Bereitstellen eines ersten hochfrequenten Ausgangssignals mit einer ersten Frequenz und einer ersten Amplitude, (B) eine mit dem ersten Ausgang verbundene erste induktive Einheit und eine mit dem ersten Ausgang verbundene erste kapazitive Einheit, (C) einen zweiten Ausgang zum Bereitstellen eines zweiten hochfrequenten Ausgangssignals mit einer zweiten Frequenz und einer zweiten Amplitude, wobei die zweite Frequenz mit der ersten Frequenz übereinstimmt und sich die zweite Amplitude von der ersten Amplitude unterscheidet, und (D) eine mit dem ersten Ausgang und mit dem zweiten Ausgang verbundene zweite induktive Einheit und eine mit dem zweiten Ausgang verbundene zweite kapazitive Einheit.

Der erfindungsgemäße spannungsgesteuerte Oszillator weist mindestens einen solchen Schwingkreis auf.

Die erfindungsgemäße integrierte Schaltung weist mindestens einen solchen Schwingkreis und/oder mindestens einen solchen spannungsgesteuerten Oszillator auf.

Das Wesen der Erfindung besteht darin, zusätzlich zu einer ersten Schwingkreisstufe mit einem ersten Ausgang zum Bereitstellen eines ersten Ausgangssignals mit einer ersten Amplitude eine zweite Schwingkreisstufe mit einem zweiten Ausgang zum Bereitstellen eines frequenzgleichen zweiten Ausgangssignals mit einer unterschiedlichen zweiten Amplitude vorzusehen, wobei die zweite Schwingkreisstufe eine mit beiden Ausgängen verbundene zweite induktive Einheit und eine mit dem zweiten Ausgang verbundene zweite kapazitive Einheit aufweist. Hierdurch wird vorteilhaft die effektive Güte des Schwingkreises sowie die Konstanz der Frequenz im Großsignalbetrieb erhöht. Weiterhin wird so ermöglicht, die Belastung des Schwingkreises durch nachgeschaltete Ausgangssignalbuffer zu reduzieren. Eine ggf. erforderliche aktive Dämpfung des Ausgangssignals entfällt vorteilhaft. Außerdem wird so ermöglicht, die Abstimmbarkeit des Schwingkreises zu verbessern.

Vorteilhafte Ausgestaltungen und Weiterbildungen der Erfindung sind den abhängigen Ansprüchen sowie der Beschreibung unter Bezugnahme auf die Zeichnung zu entnehmen.

In einer besonders vorteilhaften Ausführungsform des erfindungsgemäßen Schwingkreises ist eine dritte Schwingkreisstufe mit einem dritten Ausgang zum Bereitstellen eines frequenzgleichen dritten Ausgangssignals mit einer unterschiedlichen dritten Amplitude vorgesehen, wobei die dritte Schwingkreisstufe eine mit dem zweiten und dem dritten Ausgang verbundene dritte induktive Einheit und eine mit dem dritten Ausgang verbundene dritte kapazitive Einheit aufweist. Auf diese Weise können vorteilhaft besonders hohe Schwingkreisgüten und/oder eine besonders hohe Konstanz der Frequenz im Großsignalbetrieb erreicht werden. Weiterhin kann die Belastung des Schwingkreises durch nachgeschaltete Ausgangssignalbuffer weiter reduziert werden. Darüber hinaus wird ermöglicht, die Abstimmbarkeit des Schwingkreises weiter zu verbessern.

In einer weiteren vorteilhaften Ausführungsform des erfindungsgemäßen Schwingkreises weist mindestens eine der kapazitiven Einheiten einen einstellbaren Kapazitätswert auf und ist der Schwingkreis ausgestaltet, den einstellbaren Kapazitätswert in Abhängigkeit von mindestens einem Steuersignal einzustellen. Hierdurch wird die Abstimmbarkeit des Schwingkreises verbessert.

In einer weiteren Ausführungsform handelt es sich bei mindestens einer der kapazitiven Einheiten um eine parasitäre Kapazität. Ein solcher Schwingkreis ist besonders einfach zu implementieren.

Die Erfindung wird nachfolgend anhand der in den schematischen Figuren der Zeichnung angegebenen Ausführungsbeispiele näher erläutert. Hierbei zeigen

Fig. 1 ein erstes Ausführungsbeispiel eines erfindungsgemäßen Schwingkreises;

Fig. 2 ein zweites Ausführungsbeispiel eines erfindungsgemäßen Schwingkreises; und

Fig. 3 ein drittes Ausführungsbeispiel eines erfindungsgemäßen Schwingkreises (Draufsicht).

In den Figuren sind gleiche und funktionsgleiche Elemente und Signale - sofern nicht anders angegeben - mit denselben Bezugszeichen versehen.

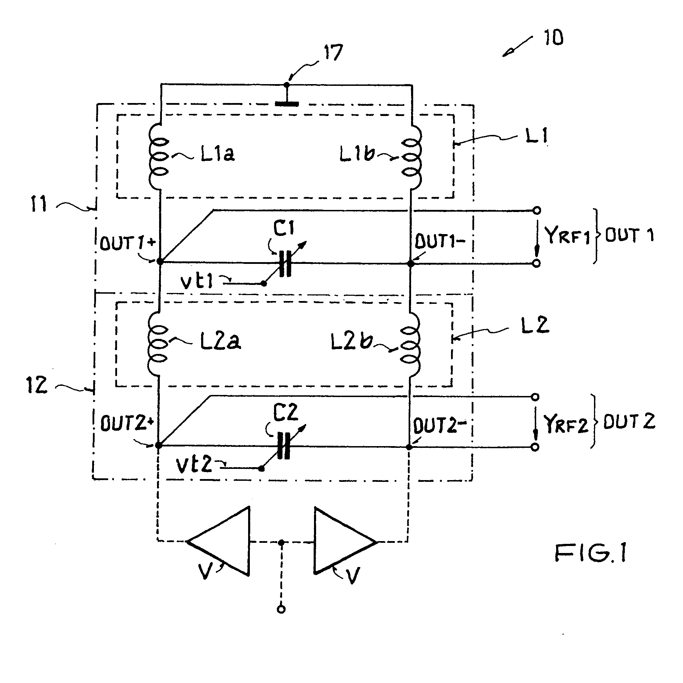

Figur 1 zeigt ein Schaltbild eines ersten Ausführungsbeispiels eines erfindungsgemäßen integrierten Schwingkreises.

Der Schwingkreis 10 weist eine erste Stufe 11 zum Bereitstellen eines ersten hochfrequenten Ausgangssignals yRF1 und eine zweite Stufe 12 zum Bereitstellen eines zweiten hochfrequenten Ausgangssignals yRF2 auf. Die erste Stufe 11 weist eine erste induktive Einheit L1, eine mit der Einheit L1 verbundene erste kapazitive Einheit C1 und einen mit beiden Einheiten L1, C1 verbundenen ersten Ausgang OUT1 zum Bereitstellen des ersten Ausgangssignals yRF1 auf. Die zweite Stufe 12 weist eine mit dem ersten Ausgang OUT1 verbundene zweite induktive Einheit L2, eine mit der Einheit L2 verbundene zweite kapazitive Einheit C2 und einen mit den beiden Einheiten L2, C2 verbundenen zweiten Ausgang OUT2 zum Bereitstellen des zweiten Ausgangssignals yRF2 auf. Die Reihenschaltung aus den beiden Einheiten L2, C2 ist parallel geschaltet zur kapazitiven Einheit C1.

Vorzugsweise ist der erfindungsgemäße Schwingkreis - wie in Fig. 1 dargestellt - differentiell realisiert. Er weist differentielle Ausgänge OUT1 und OUT2 mit jeweils zwei Anschlüssen OUT1+, OUT1- bzw. OUT2+, OUT2- auf, an denen das differentielle Signal yRF1 bzw. yRF2 abgegriffen wird. Der nichtinvertierende Anschluss OUT1+ ist mit einem ersten Anschluss der Einheit L1 und einem ersten Anschluss der Einheit C1 verbunden, während der invertierende Anschluss OUT1-mit jeweils einem anderen (zweiten) Anschluss der Einheiten L1, C1 verbunden ist. Der nichtinvertierende Anschluss OUT2+ ist mit einem ersten Anschluss der Einheit L2 und einem ersten Anschluss der Einheit C2 verbunden, während der invertierende Anschluss OUT2- mit jeweils einem anderen (zweiten) Anschluss der Einheiten L2, C2 verbunden ist.

In der differentiellen Ausführungsform des Schwingkreises weist die zweite induktive Einheit L2 zwei induktive Teilelemente L2a, L2b auf, deren Induktivitätswerte im wesentlichen (d.h. im Rahmen der Toleranzen) übereinstimmen, wobei das erste Teilelement L2a zwischen die nichtinvertierenden Anschlüsse OUT2+, OUT1+ und das zweite Teilelement L2b zwischen die invertierenden Anschlüsse OUT2-, OUT1-geschaltet ist. Damit ist eine Reihenschaltung aus den Teilelementen L2a, L2b und der kapazitiven Einheit C2 parallel geschaltet zur kapazitiven Einheit C1. Unterteilt man auch die erste induktive Einheit L1 in zwei induktive Teilelemente L1a, L1b mit im wesentlichen übereinstimmenden Induktivitätswerten, so stellt sich an deren Verbindungspunkt 17 eine sog. Wechselstrommasse (virtual ground) ein.

In einer weiteren Ausführungsform ist der erfindungsgemäße Schwingkreis nicht-differentiell (single ended) ausgeführt. Die vom Schwingkreis 10 bei entsprechender Anregung bereitgestellten hochfrequenten Ausgangssignale yRF1 und yRF2 weisen dieselbe Frequenz f0 beispielsweise im Gigahertzbereich auf. Vorzugsweise weist mindestens eine der kapazitiven Einheiten zur Einstellung der Frequenz f0 auf eine vorgegebene Zielfrequenz (z.B. im Bereich von 10 GHz bis 14 GHz) einen einstellbaren Kapazitätswert auf, der mit Hilfe mindestens eines Steuersignals eingestellt wird.

Gemäß Fig. 1 weisen beide kapazitiven Einheiten C1, C2 einen einstellbaren Kapazitätswert auf, wobei der Kapazitätswert der Einheit C1 mit Hilfe mindestens eines Steuersignals vt1 und der Kapazitätswert der Einheit C2 mittels mindestens eines Steuersignals vt2 derart eingestellt wird, daß die Frequenz f0 der Ausgangssignale yRF1, yRF2 den vorgegebenen Zielwert annimmt.

Die kapazitiven Einheiten C1, C2 können beispielsweise eine Einheit mit einem kontinuierlich veränderbaren Kapazitätswert, wie z.B. eine Varaktor-, Kapazitäts-, MOS-Diode (metal oxide semiconductor) oder einen MEM-Varaktor (mikroelektromechanisch) oder/und eine Einheit mit einem schrittweise veränderbaren Kapazitätswert aufweisen, die z.B. als geschalteter MIM-Kondensator (metal insulator metal), geschalteter Polycap oder als geschaltete Kondensatorbank (capacitive digital-to-analog converter, CDAC) ausgeführt ist. Vorzugsweise weist die kapazitive Einheit C1 eine Varaktordiode und die kapazitive Einheit C2 eine geschaltete Kondensatorbank (CDAC) auf. Alternativ kann eine der kapazitiven Einheiten oder beide Einheiten C1, C2 einen festen Kapazitätswert aufweisen. In weiteren Ausführungsformen handelt es sich bei der kapazitiven Einheit C1 oder C2 um eine parasitäre Kapazität z.B. von Verstärkungselementen, mit denen der erfindungsgemäße Schwingkreis z.B. in einem spannungsgesteuerten Oszillator zum Einsatz kommt.

Die induktiven Einheiten L1, L2 bzw. die induktiven Teilelemente L1a, L1 b, L2a, L2b sind vorzugsweise als in einer oder mehreren Metallisierungsebenen einer integrierten Schaltung angeordnete Leiterbahnen ausgebildet. Alternativ kann es sich bei einzelnen oder mehreren dieser induktiven Elemente auch um Bonddrähte oder andere Verbindungsmittel, wie z.B. kleine Lötkugeln, Flip-Chip-Übergänge etc. handeln.

Die Amplitude des ersten Ausgangssignals yRF1 ist nachfolgend mit A1 und seine Frequenz mit f1 bezeichnet. Analog hierzu bezeichnen A2 und f2 die entsprechenden Größen des zweiten Ausgangssignals yRF2.

Die Ausgangssignale yRF1 und yRF2 weisen übereinstimmende Frequenzen auf (f1= f2=f0). Sie unterscheiden sich allerdings in ihrer Amplitude, wobei die Amplitude A2 von yRF2 die Amplitude A1 von yRF1 übersteigt.

Die Amplitudenwerte A1 und A2 hängen hierbei von den Induktivitätswerten L1a=L1b, L2a=L2b und den Kapazitätswerten C1, C2 ab. Im exemplarischen Falle C1=C2 und L1a=L2a ergibt sich beispielsweise ein Amplitudenverhältnis von ca. A1/A2=0.55.

Indem Ausgangssignale bereitgestellt werden, die sich in ihrer Amplitude unterscheiden, bietet der erfindungsgemäße Schwingkreis vielfältige Vorteile.

Im Gegensatz zu einem einfachen Parallelschwingkreis aus einer Induktivität und einer parallel geschalteten Kapazität fällt beim erfindungsgemäßen Schwingkreis die volle Amplitude (A2) der Ausgangsspannung nur über einem Teil (in Fig. 1: C2) der gesamten Schwingkreiskapazität ab, während über dem verbleibenden Teil der Schwingkreiskapazität (in Fig. 1: C1) nur die reduzierte Amplitude (A1) abfällt. Ebenso fließt nur über einen Teil der gesamten Schwingkreisinduktivität (L1) der komplette Strom. Dies ist von Bedeutung, da die Güte von integrierten Bauelementen auch von ihrer Aussteuerung abhängt. So weisen z.B. Varaktordioden bei zunehmender Aussteuerung (Amplitude der Spannung) eine kontinuierlich abnehmende Güte auf, während die Güte z.B. bei geschalteten MIM-Kapazitäten bis zu einer bestimmten Aussteuerungsgrenze (Amplitudengrenzwert) im wesentlichen konstant bleibt und oberhalb dieser Grenze drastisch sinkt. Durch das Betreiben von Bauelementen mit der in dieser Hinsicht optimalen Aussteuerung kann daher vorteilhaft die effektive Güte des Schwingkreises erhöht werden, indem z.B. die kapazitive Einheit C1 als Varaktordiode ausgebildet und mit der kleineren Amplitude A1 betrieben wird, während die kapazitive Einheit C2 als geschaltete MIM-Kapazität ausgestaltet und mit der größeren Amplitude A2, aber dennoch unterhalb der genannten Aussteuerungsgrenze, betrieben wird. Auf diese Weise werden vorteilhaft kapazitive Bauelemente mit besseren Großsignaleigenschaften mit größeren Amplituden und solche mit schlechteren Großsignaleigenschaften mit kleineren Amplituden betrieben.

Weiterhin variiert der Kapazitätswert z.B. einer integrierten Diode umso stärker, je größer die Amplitude der über der Diode anliegenden Sperrspannung ist. Auch dieser unerwünschte Effekt wird durch den erfindungsgemäßen Schwingkreis vorteilhaft reduziert, indem an einem Teil der gesamten Schwingkreiskapazität (in Fig. 1: C1) eine Spannung mit reduzierter Amplitude (A1) anliegt.

Außerdem eröffnet das Bereitstellen von Ausgangssignalen mit unterschiedlichen Amplituden die Möglichkeit, in nachfolgenden Schaltungsanordnungen mehrere Ausgangssignale unterschiedlicher Amplitude zu verwenden oder aber dasjenige Signal zu verwenden bzw. auszuwählen, das für die nachfolgende Schaltungsanordnung und/oder den Schwingkreis am besten geeignet ist. So entfallen z.B. durch das Bereitstellen eines Ausgangssignals mit einer kleineren Amplitude vorteilhaft (ggf. aktive) Einheiten zur Signaldämpfung. Außerdem kann z.B. die Belastung des Schwingkreises durch nachgeschaltete Ausgangssignalbuffer vorteilhaft minimiert bzw. angepasst werden, indem ein Ausgangssignal mit einer in dieser Hinsicht optimalen (z.B. kleineren) Amplitude verwendet wird.

In einer vorteilhaften Ausführungsform sind z.B. Schaltelemente vorgesehen, die es erlauben, im Betrieb zwischen dem ersten Ausgangssignal yRF1 und dem zweiten Ausgangssignal yRF2 umzuschalten, damit das jeweils "optimale" Signal weiterverarbeitet wird.

Nachfolgend ist eine exemplarische Dimensionierung der Bauelemente des erfindungsgemäßen Schwingkreises 10 aus Fig. 1 beschrieben. Hierbei wird von einem einfachen Parallelschwingkreis ausgegangen, der eine Kapazität mit einem Kapazitätswert C und eine parallel geschaltete induktive Einheit aufweist, die aus zwei in Reihe geschalteten induktiven Teilelementen mit übereinstimmenden Induktivitätswerten La=Lb besteht. Ein solcher einfacher Parallelschwingkreis stellt genau ein Ausgangssignal yRF mit einer Frequenz f0 bereit, für die folgende Beziehung gilt:

$$(2\pi \cdot f0)^2 = 1 \mathbin{/} (2 \cdot La \cdot C) . \qquad\qquad (1)$$

Der erfindungsgemäße Schwingkreis 10 aus Fig. 1 stellt Ausgangssignale yRF1 und yRF2 mit demselben Frequenzwert f0 bereit, wenn die vier induktiven Teil-elemente L1 a, L1 b, L2a, L2b und die beiden kapazitiven Einheiten C1, C2 beispielsweise wie folgt dimensioniert sind:

$$L1a = L1b \approx (2/6) \cdot La = La/3 , \qquad\qquad (2)$$

$$L2a = L2b \approx (5/6) \cdot La , \qquad\qquad (3)$$

$$C1 = C2 = (3/5)^*C .\qquad(4)$$

Aus den Gleichungen (2) bis (4) ist zu erkennen, dass in diesem Dimensionierungsbeispiel weder die Summe der Induktivitätswerte L_tot noch die Summe der Kapazitätswerte C_tot des erfindungsgemäßen Schwingkreises mit der Summe der Induktivitäts- bzw. Kapazitätswerte des einfachen Parallelschwingkreis übereinstimmt. Die Summe der Induktivitätswerte nimmt gemäß Gleichung (2) und (3) den Wert

$$L\_tot = 2^*(L1a+L2a) = 2^*(7/6)^*La\qquad(5)$$

und damit einen höheren Induktivitätswert als beim einfachen Parallelschwingkreis (2*La) an. Auch die Summe der Kapazitätswerte liegt gemäß Gleichung (4) mit dem Wert

$$C\_tot = C1+C2 = (6/5)^*C\qquad(6)$$

oberhalb des Wertes C beim einfachen Parallelschwingkreis.

Die Dimensionierung des Schwingkreises 10 gemäß den Gleichungen (2)-(4) ist exemplarisch zu verstehen. Insbesondere ist es analog zum einfachen Parallelschwingkreis möglich, unter Konstanthalten der resultierenden Frequenz f0 Induktivitätswerte zu erhöhen und Kapazitätswerte zu reduzieren (oder umgekehrt).

Selbst wenn der Wert von C_tot konstant gehalten wird, übersteigt die Summe der Induktivitätswerte L_tot des Schwingkreises 10 den Wert 2*La des einfachen Parallelschwingkreises, so daß vorteilhaft selbst bei unveränderter Abstimmbarkeit des Schwingkreises ein Ausgangssignal (yRF2) mit im Vergleich zum einfachen Parallelschwingkreis erhöhter Amplitude (A2) bereitgestellt wird.

Kommt der Schwingkreis 10 aus Fig. 1 im Rahmen eines spannungsgesteuerten Oszillators (voltage controlled oscillator, VCO) zum Einsatz, sind zusätzlich z.B. mit dem zweiten Ausgang OUT2 verbundene Verstärkungselemente V vorgesehen, die in Fig. 1 gestrichelt dargestellt sind. Diese Verstärkungselemente (z.B. Transistoren) gleichen die Verluste im Schwingkreis aus, so dass die Amplituden der Ausgangssignale yRF1 und yRF2 nicht abklingen, sondern zeitlich konstant bleiben. In alternativen Ausführungsformen des VCO sind die Verstärkungselemente V mit dem ersten Ausgang OUT1 verbunden.

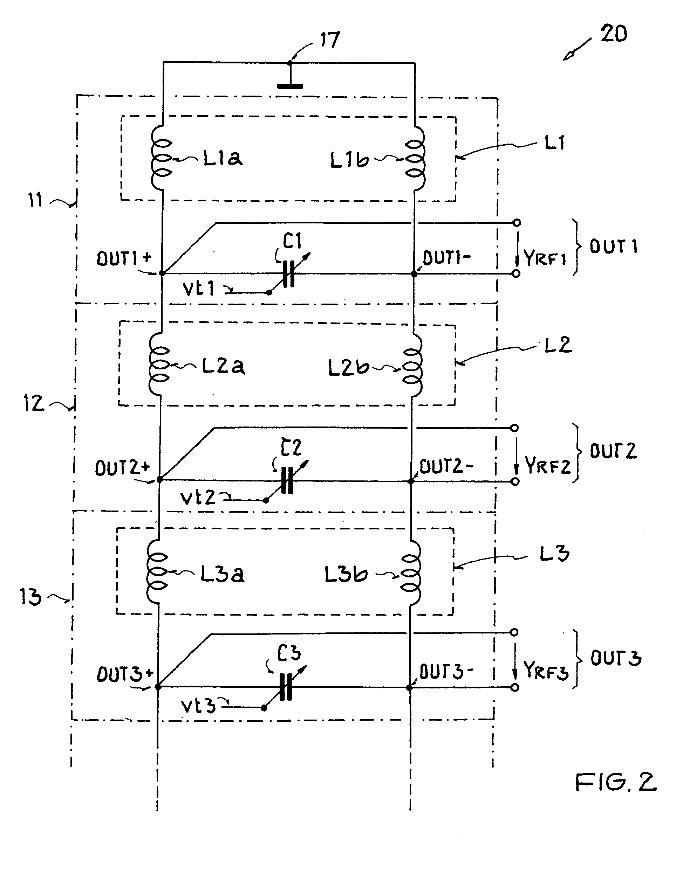

Figur 2 zeigt ein Schaltbild eines zweiten Ausführungsbeispiels eines erfindungsgemäßen integrierten Schwingkreises.

Zusätzlich zur ersten und zweiten Stufe 11 bzw. 12, die in Übereinstimmung mit dem vorstehend beschriebenen ersten Ausführungsbeispiel ausgestaltet sind, weist der Schwingkreis 20 eine weitere, dritte Stufe 13 zum Bereitstellen eines dritten hochfrequenten Ausgangssignals yRF3 auf.

Die dritte Stufe 13 weist eine mit dem zweiten Ausgang OUT2 verbundene dritte induktive Einheit L3, eine mit der Einheit L3 verbundene dritte kapazitive Einheit C3 und einen mit den beiden Einheiten L3, C3 verbundenen dritten Ausgang OUT3 zum Bereitstellen des dritten Ausgangssignals yRF3 auf. Die Reihenschaltung aus den beiden Einheiten L3, C3 ist parallel geschaltet zur kapazitiven Einheit C2.

Auch der Ausgang OUT3 weist in der bevorzugten differentiellen Ausführungsform zwei Anschlüsse OUT3+, OUT3- auf, an denen das differentielle Signal yRF3 abgegriffen wird. Der nichtinvertierende Anschluß OUT3+ ist mit einem ersten Anschluss der Einheit L3 und einem ersten Anschluss der Einheit C3 verbunden, während der invertierende Anschluss OUT3- mit jeweils einem anderen (zweiten) Anschluss der Einheiten L3, C3 verbunden ist. Auch die dritte induktive Einheit L3 weist zwei induktive Teilelemente L3a, L3b auf, deren Induktivitätswerte im wesentlichen übereinstimmen, wobei das erste Teilelement L3a zwischen die nichtinvertierenden Anschlüsse OUT3+, OUT2+ und das zweite Teilelement L3b zwischen die invertierenden Anschlüsse OUT3-, OUT2- geschaltet ist. Damit ist eine Reihenschaltung aus den Teilelementen L3a, L3b und der kapazitiven Einheit C3 parallel geschaltet zur kapazitiven Einheit C2.

Zur Einstellung der Frequenz f0 auf eine vorgegebene Zielfrequenz weist vorzugsweise auch die kapazitive Einheit C3 einen einstellbaren Kapazitätswert auf, der mit Hilfe mindestens eines Steuersignals vt3 eingestellt wird. Vorzugsweise weist die kapazitive Einheit C3 eine geschaltete Kondensatorbank (CDAC), die kapazitive Einheit C1 eine Varaktordiode und die kapazitive Einheit C2 eine Parallelschaltung mit einer Varaktordiode und einer geschalteten Kondensatorbank auf.

Die induktive Einheit L3 bzw. die induktiven Teilelemente L3a, L3b sind vorzugsweise als in einer oder mehreren Metallisierungsebenen einer integrierten Schaltung angeordnete Leiterbahnen ausgebildet. Alternativ kann es sich bei einzelnen oder mehreren induktiven Elementen auch um Bonddrähte oder andere Verbindungsmittel handeln.

Bezeichnet man die Amplitude und die Frequenz des dritten Ausgangssignals yRF3 mit A3 bzw. f3, so weist auch das Signal yRF3 eine mit den Signalen yRF1 und yRF2 übereinstimmende Frequenz auf. Die Signale yRF1, yRF2 und yRF3 unterscheiden sich jedoch in ihrer Amplitude, wobei die Amplitude A3 von yRF3 die Amplitude A2 von yRF2 übersteigt, so daß gilt: A3 > A2 > A1.

Die Amplitudenwerte A1, A2, A3 hängen hierbei von den Induktivitätswerten L1a=L1b. L2a=L2b, L3a=L3b und den Kapazitätswerten C1, C2, C3 ab. Im exemplarischen Falle C1=C2=C3 und L1a=L2a=L3a ergibt sich beispielsweise ein Amplitudenverhältnis von ca. A1/A3=0,44 und ca. A2/A3=0,8.

Auch beim zweiten Ausführungsbeispiel eines erfindungsgemäßen Schwingkreises fällt die volle Amplitude (A3) der Ausgangsspannung nur über einem Teil (in Fig. 2: C3) der gesamten Schwingkreiskapazität ab, während über dem verbleibenden Teil der Schwingkreiskapazität (in Fig. 2: C1, C2) niedrigere Amplituden (A1, A2) abfallen. Ebenso fließt nur über einen Teil der gesamten Schwingkreisinduktivität (L1) der komplette Strom. Je nach ihren Großsignaleigenschaften können die Bauelemente im zweiten Ausführungsbeispiel noch präziser, d.h. mit einer feineren Amplitudenauflösung derart ausgesteuert werden, dass sich besonders hohe Schwingkreisgüten und/oder eine besonders hohe Konstanz der Frequenz ergibt.

Außerdem können in nachfolgenden Schaltungsanordnungen bis zu drei Ausgangssignale mit unterschiedlichen Amplituden verwendet oder aber dasjenige Signal ausgewählt werden, das für die nachfolgende Schaltungsanordnung und/oder den Schwingkreis am besten geeignet ist. In einer vorteilhaften Ausführungsform sind z.B. Schaltelemente vorgesehen, die es erlauben, im Betrieb zwischen den Ausgangssignalen yRF1, yRF2 und yRF3 umzuschalten, damit das jeweils "optimale" Signal weiterverarbeitet wird.

In weiteren Ausführungsbeispielen weist der erfindungsgemäße Schwingkreis mehr als drei Stufen auf, wie in Fig. 2 durch die von den Anschlüssen OUT3+, OUT3-ausgehenden gestrichelten Leitungen veranschaulicht ist. Jede weitere Stufe, die analog zu den Stufen 11-13 aufgebaut ist, stellt ein zusätzliches Ausgangssignal mit einer unterschiedlichen Amplitude bereit. Die vorstehend mit Bezug auf das erste und zweite Ausführungsbeispiel genannten Vorteile treffen sinngemäß auch auf Ausführungsbeispiele mit mehr als drei Stufen zu.

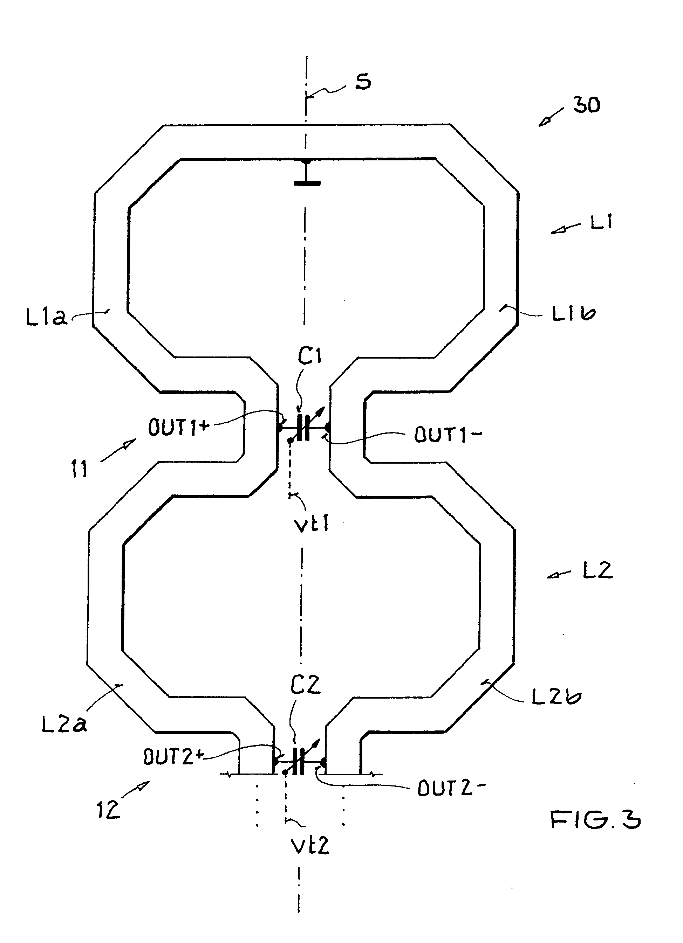

Figur 3 zeigt schematisch ein Layout eines dritten Ausführungsbeispiels eines erfindungsgemäßen Schwingkreises. Die Draufsicht gemäß Fig. 3 entspricht einem Ausschnitt aus einer horizontalen Schnittebene durch eine integrierte Schaltung mit einem erfindungsgemäßen Schwingkreis gemäß Fig. 1. Der Schwingkreis 30 weist eine erste Stufe 11 und eine zweite Stufe 12 auf.

Die erste Stufe 11 weist eine die erste induktive Einheit bildende erste Leiterschleife L1 und eine symbolisch dargestellte erste kapazitive Einheit C1 auf. Der Ausgang OUT1 befindet sich mit seinen differentiellen Anschlüssen OUT1+, OUT1- an den beiden "Enden" der Leiterschleife L1, die mit der kapazitiven Einheit C1 verbunden sind. Das nicht in Fig. 3 gezeigte differentielle Ausgangssignal yRF1 wird an den Anschlüssen OUT1+, OUT1- bereitgestellt. Die erste Leiterschleife L1 umfasst einen ersten Leiterbahnabschnitt L1 a sowie einen zweiten Leiterbahnabschnitt L1 b, die an einem ihrer Enden in einem Punkt miteinander verbunden sind, der eine Wechselstrommasse darstellt. Das andere Ende des Leiterbahnabschnittes L1a bzw. L1b ist mit dem Anschluss OUT1+ bzw. OUT1- verbunden.

Die zweite Stufe 12 weist eine die zweite induktive Einheit bildende, in ihrer Mitte unterbrochene zweite Leiterschleife L2 mit den beiden Leiterbahnabschnitten L2a, L2b und eine zweite kapazitive Einheit C2 auf. Der Ausgang OUT2 zum Bereitstellen des zweiten Ausgangssignals yRF2 ist wiederum mit der Leiterschleife L2 und der kapazitiven Einheit C2 verbunden, wobei der erste Leiterbahnabschnitt L2a zwischen die nichtinvertierenden Anschlüsse OUT1+, OUT2+ und der zweite Leiterbahnabschnitt L2b zwischen die invertierenden Anschlüsse OUT1-, OUT2-geschaltet ist. Beide Leiterschleifen L1, L2 sind im Wesentlichen symmetrisch zu einer mit S bezeichneten Schnittlinie ausgestaltet.

Gemäß Fig. 3 sind die Leiterschleifen L1, L2 im Wesentlichen identisch ausgestaltet. In weiteren Ausführungsformen unterscheiden sich die Leiterschleifen in ihren Radien, ihren Leiterbahnbreiten und/oder ihren Formen voneinander.

Vorzugsweise verkleinern sich sowohl die "Radien" der Leiterschleifen als auch die Breiten der Leiterbahnen von Stufe zu Stufe (in Fig. 3 von oben nach unten). Weiterhin können die Leiterschleifen anstelle der quasi oktaedrischen Ausprägung gemäß Figur 3 auch rechteckig, quadratisch, oval, rundlich oder mit "abgerundeten Ecken" ausgeführt sein.

In weiteren Ausführungsformen weisen die Leiterbahnabschnitte L1 a, L1b und/oder L2a, L2b eine oder mehrere volle Windungen (Schleifen) auf, die in mindestens zwei Metallisierungsebenen der integrierten Schaltung angeordnet sind. Die Anzahl der Windungen kann hierbei von Stufe zu Stufe variieren oder aber konstant bleiben.

Der anhand von Ausführungsbeispielen vorstehend beschriebene erfindungsgemäße Schwingkreis kann in unterschiedlichsten Anwendungen in Oszillator-, Resonator-, Verstärker-, Filter-, Tuner-Schaltungen etc. vorteilhaft eingesetzt werden.

Der erfindungsgemäße Schwingkreis bzw. die genannten Schaltungen sind jeweils vorzugsweise Bestandteil einer integrierten Schaltung, die z.B. als monolithisch integrierte Schaltung (z.B. application specific integrated circuit, ASIC, oder application specific standard product, ASSP), als Hybridschaltung (Dünn- bzw.

Dickschichttechnologie) oder als Multilayer-Keramik-Schaltungsanordnung ausgebildet ist.

## Bezugszeichenliste

| | |
|---|---|
| 10 | Schwingkreis |
| 11 | erste Stufe |
| 12 | zweite Stufe |
| 13 | dritte Stufe |
| 17 | Verbindungspunkt |
| 20, 30, 40 | Schwingkreis |

| | |
|---|---|
| ASIC | application specific integrated circuit |
| ASSP | application specific standard product |
| CDAC | capacitive digital-to-analog-converter, geschaltete Kondensatorbank |
| IC | integrated circuit |
| MEM | mikroelektromechanisch |
| MIM | metal-isolator-metal |
| MOS | metal-oxide-semiconductor |
| MOSFET | metal-oxide-semiconductor field effect transistor |
| RF | radio frequency |
| VCO | voltage controlled oscillator |

| | |
|---|---|
| A1, A2, A3 | Amplitude des Signals yRF1 bzw. yRF2 ... |
| C_tot | Summe der Kapazitätswerte |
| C1, C2, C3 | kapazitive Einheit; Kapazitätswert der kapazitiven Einheit |
| f, f0 | Frequenz bzw. Zielfrequenz / Resonanzfrequenz |
| f1, f2, f3 | Frequenz der Ausgangssignale yRF1, yRF2, yRF3 |
| L_tot | Summe der Induktivitätswerte |
| L1, L2, L3 | induktive Einheit; Leiterschleife |
| L1a, L1b | induktives Teilelement; Leiterbahnabschnitt; Induktivitätswert |
| L2a, L2b | induktives Teilelement; Leiterbahnabschnitt; Induktivitätswert |
| L3a, L3b | induktives Teilelement; Leiterbahnabschnitt; Induktivitätswert |
| out1, out2, ... | Ausgang |
| vt1, vt2, ... | Steuersignal |
| yRF1, yRF2, ... | Ausgangssignal |

## Patentansprüche

1. Integrierter Schwingkreis (10; 20; 30) zum Bereitstellen eines hochfrequenten Ausgangssignals, beinhaltend:

a) einen ersten Ausgang (OUT1) zum Bereitstellen eines ersten hochfrequenten Ausgangssignals (yRF1) mit einer ersten Frequenz (f1) und einer ersten Amplitude (A1),
b) eine mit dem ersten Ausgang (OUT1) verbundene erste induktive Einheit (L1) und eine mit dem ersten Ausgang (OUT1) verbundene erste kapazitive Einheit (C1), wobei
c) ein zweiter Ausgang (OUT2) zum Bereitstellen eines zweiten hochfrequenten Ausgangssignals (yRF2) mit einer zweiten Frequenz (f2) und einer zweiten Amplitude (A2) vorgesehen ist, wobei die zweite Frequenz (f2) mit der ersten Frequenz (f1) übereinstimmt und sich die zweite Amplitude (A2) von der ersten Amplitude (A1) unterscheidet, und
d) eine mit dem ersten Ausgang (OUT1) und mit dem zweiten Ausgang (OUT2) verbundene zweite induktive Einheit (L2) und eine mit dem zweiten Ausgang (OUT2) verbundene zweite kapazitive Einheit (C2) vorgesehen ist.

2. Schwingkreis nach Anspruch 1, **dadurch gekennzeichnet, dass** eine Reihenschaltung aus der zweiten induktiven Einheit (L2) und der zweiten kapazitiven Einheit (C2) parallel zur ersten kapazitiven Einheit (C1) geschaltet ist.

**3.** Schwingkreis nach Anspruch 1 oder 2, **dadurch gekennzeichnet, dass die** zweite induktive Einheit (L2) zwei induktive Teilelemente (L2a, L2b) aufweist, die jeweils mit dem ersten Ausgang (OUT1) und mit dem zweiten Ausgang (OUT2) verbunden sind.

**4.** Schwingkreis nach einem der vorhergehenden Ansprüche, **dadurch gekennzeichnet, dass** die zweite Amplitude (A2) die erste Amplitude (A1) übersteigt.

**5.** Schwingkreis (20) nach einem der vorhergehenden Ansprüche, **dadurch gekennzeichnet, dass**

a) ein dritter Ausgang (OUT3) zum Bereitstellen eines dritten hochfrequenten Ausgangssignals (yRF3) mit einer dritten Frequenz (f3) und einer dritten Amplitude (A3) vorgesehen ist, wobei die dritte Frequenz (f3) mit der ersten Frequenz (f1) übereinstimmt und sich die dritte Amplitude (A3) von der ersten Amplitude (A1) und der zweiten Amplitude (A2) unterscheidet, und
b) eine mit dem zweiten Ausgang (OUT2) und mit dem dritten Ausgang (OUT3) verbundene dritte induktive Einheit (L3) und eine mit dem dritten Ausgang (OUT3) verbundene dritte kapazitive Einheit (C3) vorgesehen ist.

**6.** Schwingkreis nach Anspruch 5, **dadurch gekennzeichnet, dass eine** Reihenschaltung aus der dritten induktiven Einheit (L3) und der dritten kapazitiven Einheit (C3) parallel zur zweiten kapazitiven Einheit (C2) geschaltet ist.

**7.** Schwingkreis nach Anspruch 5 oder 6, **dadurch gekennzeichnet, dass die dritte** induktive Einheit (L3) zwei induktive Teilelemente (L3a, L3b) aufweist, die jeweils mit dem zweiten Ausgang (OUT2) und mit dem dritten Ausgang (OUT3) verbunden sind.

**8.** Schwingkreis nach einem der Ansprüche 5 bis 7, **dadurch gekennzeichnet, dass** die dritte Amplitude (A3) die zweite Amplitude (A2) übersteigt.

**9.** Schwingkreis nach einem der vorhergehenden Ansprüche, **dadurch gekennzeichnet, dass mindestens** eine der induktiven Einheiten (L1-L3) mindestens eine Leiterschleife aufweist.

**10.** Schwingkreis nach einem der vorhergehenden Ansprüche, **dadurch gekennzeichnet, dass mindestens eine der induktiven Einheiten** (L1-L3) mindestens einen Bonddraht, eine Lötkugel oder einen Flip-Chip-Übergang aufweist.

**11.** Schwingkreis nach einem der vorhergehenden Ansprüche, **dadurch gekennzeichnet, dass mindestens eine der kapazitiven Einheiten** (C1-C3) einen einstellbaren Kapazitätswert aufweist und der Schwingkreis ausgestaltet ist, den einstellbaren Kapazitätswert in Abhängigkeit von mindestens einem Steuersignal (vt1-vt3) einzustellen.

**12.** Schwingkreis nach einem der vorhergehenden Ansprüche, **dadurch gekennzeichnet, dass mindestens** eine der kapazitiven Einheiten (C1-C3) mindestens einen Metall-Isolator-Metall-Kondensator (MIM), einen Varaktor, einen geschalteten MIM-Kondensator oder eine geschaltete Kondensatorbank (CDAC) aufweist.

**13.** Schwingkreis nach einem der vorhergehenden Ansprüche, **dadurch gekennzeichnet, dass es sich** bei mindestens einer der kapazitiven Einheiten (C1-C3) um eine parasitäre **Kapazität** handelt.

**14.** Schwingkreis nach einem der vorhergehenden Ansprüche, **dadurch gekennzeichnet, dass** die erste induktive Einheit (L1) als Leiterschleife mit einer oder mehreren Windungen ausgestaltet ist.

**15.** Spannungsgesteuerter Oszillator mit mindestens **einem Schwingkreis nach** einem der vorhergehenden **Ansprüche**.

**16.** integrierte Schaltung mit mindestens einem Schwingkreis nach einem der Ansprüche 1 bis 14 und/oder mindestens einem spannungsgesteuerten Oszillator nach Anspruch 15.

**17.** integrierte Schaltung nach Anspruch 16, dadurch **gekennzeichnet, dass die** integrierte Schaltung als monolithisch integrierte Schaltung, als Hybridschaltung oder als Multilayer-Keramik-Schaltung ausgebildet ist.

FIG.1

FIG. 2

FIG.3

**Europäisches Patentamt**    **EUROPÄISCHER RECHERCHENBERICHT**

Nummer der Anmeldung

EP 07 00 6777

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | WU H ET AL: "Differential 4-tap and 7-tap transverse filters in SiGe for 10Gb/s multimode fiber optic link equalization" SOLID-STATE CIRCUITS CONFERENCE, 2003. DIGEST OF TECHNICAL PAPERS. ISSCC. 2003 IEEE INTERNATIONAL SAN FRANCISCO, CA, USA 9-13 FEB. 2003, PISCATAWAY, NJ, USA,IEEE, US, 9. Februar 2003 (2003-02-09), Seiten 1-10, XP010661369 ISBN: 0-7803-7707-9 1. Seite, linke Spalte, 4. Absatz * Abbildung 10.4.2 * * Abbildungen 10.4.3,10.4.4 * * Abbildung 10.4.7 * | 1-17 | INV.<br>H03B5/18<br>H01P7/08<br>H03B5/12<br>H03H7/01 |
| X | US 5 561 398 A (RASMUSSEN RICHARD R [US]) 1. Oktober 1996 (1996-10-01) * Spalte 3, Zeilen 27-49; Abbildung 6 * * Abbildungen 3,5 * * Spalte 4, Zeilen 8-24 * * Anspruch 8 * | 1,2,4-6, 8-17 | |
| A | WO 98/27643 A (ERICSSON TELEFON AB L M [SE]; BLADH MATS [SE]) 25. Juni 1998 (1998-06-25) * Abbildung 4 * | 1-17 | RECHERCHIERTE SACHGEBIETE (IPC)<br><br>H03B<br>H01P<br>H03H |
| A | JP 08 222916 A (NIPPON CHEMICON) 30. August 1996 (1996-08-30) * Zusammenfassung; Abbildung * | 1-17 | |
| A | US 2004/056738 A1 (AIGA FUMIHIKO [JP] ET AL) 25. März 2004 (2004-03-25) * Abbildung 2 * | 1-17 | |

Der vorliegende Recherchenbericht wurde für alle Patentansprüche erstellt

| Recherchenort | Abschlußdatum der Recherche | Prüfer |
|---|---|---|
| München | 20. Juni 2007 | Robinson, Victoria |

EPO FORM 1503 03.82 (P04C03)

EP 1 858 155 A1

**ANHANG ZUM EUROPÄISCHEN RECHERCHENBERICHT
ÜBER DIE EUROPÄISCHE PATENTANMELDUNG NR.**

EP 07 00 6777

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

20-06-2007

| Im Recherchenbericht angeführtes Patentdokument | Datum der Veröffentlichung | Mitglied(er) der Patentfamilie | Datum der Veröffentlichung |
|---|---|---|---|
| US 5561398 A | 01-10-1996 | KEINE | |
| WO 9827643 A | 25-06-1998 | AU 5352698 A<br>EP 0947045 A1<br>SE 9604691 A | 15-07-1998<br>06-10-1999<br>20-06-1998 |
| JP 8222916 A | 30-08-1996 | KEINE | |
| US 2004056738 A1 | 25-03-2004 | JP 2004112668 A | 08-04-2004 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6778022 B1